# EUROPÄISCHE PATENTSCHRIFT

(11) **EP 2 825 686 B1**
(45) Veröffentlichungstag und Bekanntmachung des Hinweises auf die Patenterteilung: **29.04.2020**
(21) Anmeldenummer: 12818870.3
(22) Anmeldetag: 28.12.2012
(51) Int. Cl.: C23C 16/34, C23C 30/00

(54) **BESCHICHTETER KÖRPER UND VERFAHREN ZUM BESCHICHTEN EINES KÖRPERS**
COATED BODY AND METHOD FOR COATING A BODY
CORPS REVÊTU ET PROCÉDÉ POUR REVÊTIR UN CORPS

(30) Priorität: 14.03.2012 AT 500802012
(43) Veröffentlichungstag der Anmeldung: 21.01.2015
(73) Patentinhaber: BOEHLERIT GmbH & Co.KG., 8605 Kapfenberg (AT)
(72) Erfinder: PITONAK, Reinhard, A-8600 Bruck an der Mur (AT); KÖPF, Arno, A-8605 Kapfenberg (AT); WEISSENBACHER, Ronald, 8600 Bruck an der Mur (AT)
(74) Vertreter: Wirnsberger, Gernot
(86) Internationale Anmeldenummer: PCT/AT2012/050209
(87) Internationale Veröffentlichungsnummer: WO 2013/134796

(56) Entgegenhaltungen:
- EP-A1- 1 795 628
- EP-A1- 2 008 743
- EP-A2- 0 709 483
- WO-A1-2012/126030
- DE-A1-102005 032 860
- US-A1- 2008 299 366
- ENDLER I ET AL: "Aluminum-rich Ti1-xAlxN coatings by CVD", PM IN BELGIUM, A CROSSROADS IN INDUSTRY DEVELOPMENT: EURO PM 2006 CONGRESS & EXHIBITION; 23 - 25 OCTOBER 2006, GHENT, BELGIUM, PROCEEDINGS, POWDER METALLURGY CONGRESS & EXHIBITION, EUROPEAN POWDER METALLURGY ASSOCIATION, SHREWSBURY, Bd. 1, 25. Oktober 2006 (2006-10-25), Seiten 219-224, XP008105516, ISBN: 978-1-899072-32-3 in der Anmeldung erwähnt

## Beschreibung

Die Erfindung betrifft einen Körper, insbesondere Schneideinsatz, der zumindest bereichsweise eine Beschichtung aufweist, wobei die Beschichtung aus einer oder mehreren Beschichtungslagen gebildet ist, wobei zumindest eine Beschichtungslage Aluminium, Titan und Stickstoff umfasst oder aus diesen Elementen gebildet ist.

Des Weiteren betrifft die Erfindung ein Verfahren zum Beschichten eines Körpers, insbesondere eines Schneideinsatzes, wobei zumindest bereichsweise eine Beschichtung aufgebracht wird, die aus einer oder mehreren Beschichtungslagen gebildet wird, wobei zumindest eine Beschichtungslage mit Aluminium, Titan und Stickstoff gebildet wird.

Aus dem Stand der Technik ist es bekannt, dass Schneidwerkzeuge oder Schneideinsätze zur Erhöhung einer Standzeit im Schneideinsatz mit Beschichtungslagen beschichtet werden, die aus Titan, Aluminium und Stickstoff zusammengesetzt sind. Allgemein wird diesbezüglich oftmals von TiAlN-Beschichtungslagen gesprochen, wobei eine durchschnittliche chemische Zusammensetzung, unabhängig davon, ob eine oder mehrere Phasen in der Beschichtungslage vorliegen, mit Ti₁₋ₓAlₓN angegeben wird. Für Beschichtungslagen, die mehr Aluminium als Titan enthalten, ist auch die Nomenklatur AlTiN bzw. genauer AlₓTi₁₋ₓN gebräuchlich.

Aus der WO 03/085152 A2 ist es bekannt, im System AlTiN monophasige Beschichtungslagen mit einer kubischen Struktur herzustellen, wobei bei einem relativen Anteil von Aluminiumnitrid (AlN) bis zu 67 Molprozent (Mol-%) eine kubische Struktur des AlTiN erhalten wird. Bei höheren AlN-Gehalten von bis zu 75 Mol-% entsteht ein Gemisch aus kubischem AlTiN und hexagonalem AlN und bei einem AlN-Gehalt von mehr als 75 Mol-% ausschließlich hexagonales AlN und kubisches Titannitrid (TiN). Gemäß der genannten Druckschrift werden die beschriebenen AlTiN-Beschichtungslagen mittels Physical Vapor Deposition (PVD) abgeschieden. Mit einem PVD-Verfahren sind somit maximale relative Anteile von AlN praktisch auf 67 Mol-% beschränkt, da sonst ein Umkippen in Phasen möglich ist, die Aluminium nur in Form von hexagonalem AlN enthalten. Ein höherer relativer Anteil von AlN in einer kubischen Phase ist jedoch nach Fachmeinung erwünscht, um eine Verschleißbeständigkeit möglichst zu maximieren.

Aus dem Stand der Technik ist es auch bekannt, anstelle von PVD-Verfahren Chemical Vapor Deposition (CVD) einzusetzen, wobei ein CVD-Verfahren bei relativ niedrigen Temperaturen im Temperaturfenster von 700 °C bis 900 °C durchzuführen ist, da kubische AlTiN-Beschichtungslagen bei Temperaturen von z. B. ≥ 1000 °C aufgrund der metastabilen Struktur derartiger Beschichtungslagen nicht herstellbar sind. Gegebenenfalls können die Temperaturen gemäß der US 6,238,739 B1 auch noch tiefer liegen, und zwar im Temperaturfenster von 550 °C bis 650 °C, wobei allerdings hohe Chlorgehalte in der Beschichtungslage in Kauf zu nehmen sind, was sich für einen Anwendungsfall als nachteilig erweist. Man hat daher versucht, CVD-Verfahren so zu optimieren, dass mit diesen AlTiN-Beschichtungslagen mit einem hohen Anteil von Aluminium und kubischer Struktur der Beschichtungslage herstellbar sind (I. Endler et al., Proceedings Euro PM 2006, Ghent, Belgien, 23. bis 25. Oktober 2006, Vol. 1, 219). Wenngleich diese Beschichtungslagen eine hohe Mikrohärte und damit grundsätzlich günstige Eigenschaften für eine hohe Verschleißbeständigkeit im Einsatz aufweisen, so hat es sich doch erwiesen, dass eine Haftfestigkeit derartiger Beschichtungslagen zu gering sein kann. Diesbezüglich wurde daher in der DE 10 2007 000 512 B3 vorgeschlagen, unterhalb einer kubischen AlTiN-Beschichtungslage, die 3 µm dick ist, eine 1 µm dicke Beschichtungslage vorzusehen, die als Phasengradientenschicht ausgebildet ist und aus einem Phasengemisch aus hexagonalem AlN, TiN und kubischem AlTiN besteht, wobei ein kubischer AlTiN-Anteil mit nach außen hin bzw. zur (ausschließlich) kubischen AlTiN-Beschichtungslage einen steigenden Anteil aufweist. Entsprechend beschichtete Schneidplatten wurden zu einem Fräsen von Stahl eingesetzt, wobei allerdings gegenüber Beschichtungslagen, die mittels eines PVD-Verfahrens hergestellt wurden, lediglich geringe Verbesserungen einer Verschleißfestigkeit erzielt wurden.

Neben der nur geringen Verbesserung einer Verschleißfestigkeit besteht ein weiterer Nachteil einer Anbindungsschicht gemäß der DE 10 2007 000 512 B3 darin, dass die Anbindungs- bzw. Phasengradientenschicht äußerst schnell aufwächst, auch bei Versuchen im Labormaßstab (I. Endler et al., Proceedings Euro PM 2006, Ghent, Belgien, 23. bis 25. Oktober 2006, Vol. 1, 219). Dies führt bei einer Herstellung in einem größeren Reaktor, der für ein großtechnisches Beschichten von Schneidplatten ausgelegt ist, dazu, dass die Anbindungs- bzw. Phasengradientenschicht im vorgesehenen Beschichtungsprozess äußerst dick wird, da eine Temperatur zur Ausbildung der letztlich vorgesehenen kubischen AlTiN abzusenken ist, was entsprechende Zeit erfordert. Während dieser Absenkung einer Prozesstemperatur wächst jedoch eine Dicke der Anbindungs- bzw. Phasengradientenschicht rasch an, weil in einem großtechnischen Reaktor eine schnelle Abkühlung nicht möglich ist. Denkbar wäre es, den Beschichtungsprozess für längere Zeit bzw. das Abkühlen zu unterbrechen, was allerdings nicht wirtschaftlich ist. Weitere Dokumente des Standes der Technik sind EP0709 483, US2008/299366, EP2008743, EP1795628 und WO2012/126030.

Bei der Herstellung von AlTiN-Beschichtungslagen mittels eines CVD-Verfahrens ist man bislang davon ausgegangen, dass verschleißfeste und oxidationsbeständige, somit optimale Beschichtungslagen erzielbar sind, wenn ein Aluminiumgehalt in der Beschichtungslage möglichst hoch ist und die Beschichtungslage nach Möglichkeit eine vollständig kubische Struktur aufweist.

Im Rahmen der gegenständlichen Erfindung wurde erkannt, dass bestimmte Ausbildungen einer AlTiN-Beschichtungslage zu äußerst verschleißfesten und oxidationsbeständigen Beschichtungslagen führen können, ohne dass ein außerordentlich hoher Aluminiumgehalt und/oder eine weitgehend kubische Struktur gegeben sein muss.

Dementsprechend ist es Aufgabe der Erfindung, einen Körper der eingangs genannten Art anzugeben, der eine Beschichtungslage aufweist, die im Einsatz eine gute Verschleißfestigkeit sowie eine dergleichen Oxidationsbeständigkeit aufweist.

Eine weitere Aufgabe ist es, ein Verfahren der eingangs genannten Art anzugeben, mit dem ein Körper mit einer hoch verschleißfesten und oxidationsbeständigen Beschichtungslage herstellbar ist.

Die erste Aufgabe wird erfindungsgemäß durch einen Körper der eingangs genannten Art gelöst, bei dem die Beschichtungslage mit Aluminium, Titan und Stickstoff zumindest teilweise Lamellen mit einer Lamellendicke von weniger als 100 nm aufweist, wobei die Lamellen aufeinanderfolgende Abschnitte mit unterschiedlichen Phasen umfassen.

Ein Vorteil eines erfindungsgemäßen Körpers mit einer zumindest teilweise vorhandenen Lamellenstruktur mit unterschiedlichen Phasen und einer Lamellendicke von weniger als 100 nm besteht darin, dass eine außerordentlich hohe Festigkeit und damit in der Folge auch Verschleißfestigkeit gegeben ist. Eine Lamelle stellt dabei jeweils eine Abfolge von zwei Phasen dar, die sich in einem Korn der Beschichtungslage wiederholt.

Die im Rahmen der Erfindung gewonnenen Kenntnisse scheinen mit Erfahrungen aus PVD-Verfahren zu korrelieren. Beschichtungslagen, die mittels eines PVD-Verfahrens hergestellt werden, weisen oft eine hohe Festigkeit auf, wenn auf einem zu beschichtenden Körper eine Beschichtungslage aufgrund einer Verfahrensführung quasi durch wiederholtes Abscheiden von dünnen Lagen im Nanometer-Bereich aufgebaut wird. Damit im Einklang ist es erfindungsgemäß bevorzugt, dass die Lamellendicke weniger als 50 nm, vorzugsweise weniger als 35 nm, insbesondere weniger als 25 nm, beträgt.

In einer Beschichtungslage mit Aluminium, Titan und Stickstoff eines erfindungsgemäßen Körpers bilden in der Regel mehrere Lamellen oder eine Vielzahl davon Kristallite oder Körner. Die einzelnen Kristallite sollen dabei zumindest teilweise in einem Querschnitt eine Breite von mehr als 50 nm, vorzugsweise 50 bis 200 nm, aufweisen. Ist die Kristallitgröße kleiner, kann es dazu kommen, dass sich die Wirkungen der Lamellenstruktur mit unterschiedlichen Phasen nicht voll entfaltet.

Besonders günstig ist es, dass die Lamellen mit wechselweise ersten Abschnitten, die überwiegend oder ausschließlich aus einer kubischen Phase bestehen, und zweiten Abschnitten, die überwiegend oder ausschließlich aus einer hexagonalen Phase bestehen, gebildet sind. Diese Abfolge einer harten, kubischen Phase mit einer weicheren, hexagonalen Phase scheint eine gewünschte Festigkeit zu begünstigen und damit letztlich auch eine Verschleißfestigkeit. Dabei ist es insbesondere günstig, wenn die ersten Abschnitte kubisches TiN und/oder kubisches AlₓTi₁₋ₓN aufweisen oder im Wesentlichen aus diesen Phasen bestehen. Die zweiten Abschnitte können hexagonales AIN aufweisen oder aus diesem gebildet sein. Dabei ist es insbesondere auch vorteilhaft, dass die ersten Abschnitte in einem Querschnitt dünner als die zweiten Abschnitte ausgebildet sind. Das Wechselspiel zwischen Abfolge einer harten kubischen Phase und einer weicheren hexagonalen Phase begünstigt offenbar die Festigkeit aufgrund der speziellen Ausbildung der Struktur im Nanometer-Bereich; dabei sollte der weichere hexagonale Anteil überwiegen.

In der Beschichtungslage mit Aluminium, Titan und Stickstoff können eine kubische TiN-, eine hexagonale AlN- und eine kubische AlₓTi₁₋ₓN-Phase vorliegen, wobei in der kubischen TiN-Phase Aluminium mit geringeren molaren Anteilen als Titan und in der hexagonalen AlN-Phase Titan mit geringeren molaren Anteilen als Aluminium vorliegen kann. Dabei ist ein Anteil an hexagonaler AlN-Phase in der Beschichtungslage insgesamt zumindest 5 %, vorzugsweise 5 bis 50 %, insbesondere 10 bis 35 % (in Mol-%). Im Unterschied zu den Erwartungen gemäß dem Stand der Technik, wonach ein möglichst hoher kubischer Anteil in entsprechenden Beschichtungslagen angestrebt wird, ist es durchaus günstig, wenn ein bestimmter Mindestgehalt an hexagonaler AlN-Phase vorliegt.

Die zumindest eine Beschichtungslage mit Aluminium, Titan und Stickstoff ist mittels eines CVD-Verfahrens abgeschieden.

Günstig hat es sich auch erwiesen, wenn die zumindest eine Beschichtungslage mit Aluminium, Titan und Stickstoff auf einer weiteren Beschichtungslage abgeschieden ist, die längliche Kristalle aus TiCN aufweist, die sich im Mittel etwa normal zur Oberfläche der weiteren Beschichtungslage erstrecken. Auf einer derartigen Zwischenschicht lässt sich eine Beschichtungslage mit der erfindungsgemäß vorgesehenen Lamellenstruktur im Nanometer-Bereich besonders gut ausbilden bzw. mit einem hohen Anteil der gewünschten Struktur abscheiden. Dabei sind die Beschichtungslagen in der Regel auf einem Grundkörper aus einem Hartmetall abgeschieden, beispielsweise um einen Schneideinsatz zur Verfügung zu stellen.

Die verfahrensmäßige Aufgabe der Erfindung wird gelöst, wenn bei einem Verfahren der eingangs genannten Art die Beschichtungslage mit Aluminium, Titan und Stickstoff zumindest teilweise mit einer lamellenartigen Struktur mit Lamellen mit einer Lamellendicke von weniger als 100 nm und aufeinanderfolgenden Abschnitten mit unterschiedlichen Phasen abgeschieden wird nach den Ansprüchen 1 und 12.

Ein mit einem erfindungsgemäßen Verfahren erzielter Vorteil besteht darin, dass ein Körper bereitgestellt werden kann, der mit einer verschleißfesten und oxidationsbeständigen Beschichtungslage ausgebildet ist. Dies ist auf die spezielle Ausbildung der Beschichtungslage mit Aluminium, Titan und Stickstoff mit einer lamellenartigen Struktur im Nanometer-Bereich und aufeinanderfolgenden Abschnitten mit unterschiedlichen Phasen zurückzuführen.

Die zumindest eine Beschichtungslage mit Aluminium, Titan und Stickstoff wird mittels eines CVD-Verfahrens abgeschieden. Dabei kann die zumindest eine Beschichtungslage mit Aluminium, Titan und Stickstoff gleichzeitig auf einer Vielzahl von Körpern abgeschieden werden, was eine sehr wirtschaftliche Produktion von beispielsweise Schneideinsätzen wie Schneidplatten ermöglicht. Hierbei ist es bevorzugt, dass ein Beschichten in einer Anlage erfolgt, in welche die Körper gleichzeitig eingebracht werden. Die weiteren Beschichtungslagen können dann ebenfalls mittels eines CVD-Verfahrens abgeschieden werden.

Die Einstellung einer lamellenartigen Struktur lässt sich besonders einfach erreichen, wenn die zumindest eine Beschichtungslage aus Aluminium, Titan und Stickstoff bei einem Druck von mehr als 20 mbar, bevorzugt 20 bis 80 mbar, abgeschieden wird. Dabei kann der Druck während des Beschichtens durch Zuführen eines Prozessgases eingestellt werden.

Die zumindest eine Beschichtungslage mit Aluminium, Titan und Stickstoff wird bevorzugt bei einer Temperatur von 800 °C bis 830 °C abgeschieden. Dabei ist es besonders günstig, wenn die zumindest eine Beschichtungslage mit Aluminium, Titan und Stickstoff aus einer Gasphase abgeschieden wird, bei der ein molares Verhältnis von Aluminium zu Titan kleiner als 5,0, vorzugsweise kleiner als 4,5, insbesondere 2,5 bis 4,2, ist. Durch eine entsprechende Temperaturwahl und Auswahl eines molaren Verhältnisses von Aluminium zu Titan kann eine besonders weitgehende Ausbildung mit der gewünschten Lamellenstruktur und Kristalliten erreicht werden, die eine Größe von etwa 80 bis 200 nm aufweisen.

Die Erfindung ist nachfolgend anhand eines Ausführungsbeispiels noch weitergehend erläutert. In den Zeichnungen, auf welche dabei Bezug genommen wird, zeigen:
Fig. 1 einen beschichteten Körper in schematischer Darstellung;
Fig. 2 eine Aufnahme einer Beschichtungslage eines Körpers gemäß Fig. 1 mit einem Transmissionselektronenmikroskop;
Fig. 3 einen vergrößerten Ausschnitt aus der Darstellung in Fig. 2;
Fig. 4 einen vergrößerten Ausschnitt aus der Darstellung in Fig. 3;
Fig. 5 eine Darstellung einer chemischen Analyse mittels Transmissionselektronenmikroskopie.

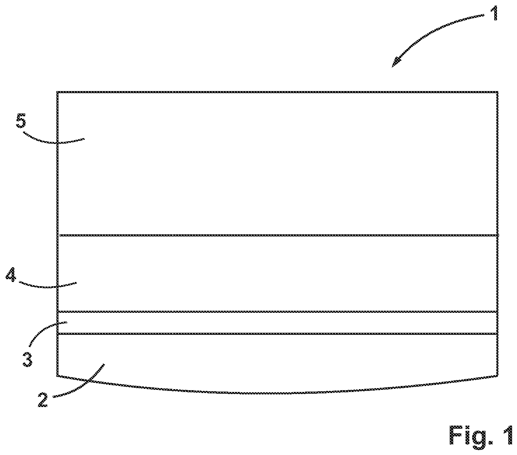

In Fig. 1 ist ein erfindungsgemäßer Körper 1 dargestellt. Der Körper 1 umfasst einen Grundkörper 2, der üblicherweise aus einem Hartmetall, das aus Carbiden und/oder Carbonitriden von Wolfram, Titan, Niob oder anderen Metallen und einem Bindemetall ausgewählt aus der Gruppe Cobalt, Nickel und/oder Eisen besteht. Ein Bindemetallanteil beträgt dabei in der Regel bis zu 10 Gew.-%. Typischerweise besteht der Körper 1 aus bis zu 10 Gew.-% Cobalt und/oder anderen Bindemetallen, Rest Wolframcarbid und bis zu 5 Gew.-% weitere Carbide und/oder Carbonitride anderer Metalle. Auf dem Grundkörper 2 ist eine als Anbindungsschicht dienende Beschichtungslage 3 aus TiN abgeschieden. Die Beschichtungslage 3 weist in der Regel eine Dicke von weniger als 2 µm, vorzugsweise 0,4 bis 1,2 µm, auf. Auf der Beschichtungslage 3 ist eine als Zwischenschicht dienende Beschichtungslage 4 aus TiCN abgeschieden. Bei dieser Beschichtungslage 4 handelt es sich um eine Mitteltemperatur-TiCN-(MT-TiCN-)Beschichtungslage. Eine derartige Beschichtungslage 4 weist in der Regel eine kolumnare Struktur mit stängeligen Kristallen auf, die im Wesentlichen parallel zur Oberflächenormalen auf den Körper 1 ausgerichtet sind. Auf der Beschichtungslage 4 ist schließlich eine äußerste Beschichtungslage 5 abgeschieden. Die Beschichtungslage 5 ist mit Aluminium, Titan und Stickstoff gebildet und wie die anderen Beschichtungslagen 3, 4 mittels eines CVD-Verfahrens abgeschieden. Je nach Verfahrensführung bzw. eingesetzten Gasen können in der Beschichtungslage 5 auch geringere Anteile von Chlor und Sauerstoff vorliegen.

Eine Beschichtung wie in Fig. 1 dargestellt kann auf einem Schneideinsatz, insbesondere einer Schneidplatte, abgeschieden werden, indem der Körper 1 bereitgestellt wird, wonach in einem ersten Schritt die Anbindungsschicht bzw. Beschichtungslage 3 aus TiN bei einer Prozesstemperatur von 880 °C bis 900 °C aus einem Gas enthaltend Stickstoff, Wasserstoff und Titantetrachlorid abgeschieden wird. Anschließend wird die Temperatur abgesenkt und bei einer Temperatur von 830 bis 870 °C eine aus MT-TiCN gebildete Beschichtungslage 4 mit einer Dicke von 2 bis 5 µm abgeschieden. Die Abscheidung erfolgt dabei aus einem Gas bestehend aus Stickstoff, Wasserstoff, Acetonitril und Titantetrachlorid. Die entsprechende Verfahrenstemperatur und der Einsatz von Acetonitril als Kohlenstoff- bzw. Stickstoffquelle stellt eine Ausbildung der Zwischenschicht mit kolumnaren Wachstum bzw. stängeligen Kristallen aus TiCN sicher. Die TiCN-Beschichtungslage weist dabei im Querschnitt längserstreckte Kristalle auf, die vorzugsweise überwiegend in einem Winkel von ±30° zu einer Oberflächennormalen des Körpers 1 verlaufen. Bei einer entsprechenden TiCN-Beschichtungslage ergibt sich eine gute Anbindung der nachfolgend abgeschiedenen Beschichtungslage 5 mit einer durchschnittlichen AlₓTi₁₋ₓN. Diesbezüglich ist es zweckmäßig, dass die TiCN-Beschichtungslage eine durchschnittliche Zusammensetzung TiCₐN₁₋ₐ mit a im Bereich von 0,3 bis 0,8, insbesondere 0,4 bis 0,6, aufweist.

Auf der Zwischenschicht aus TiCN, bei der Titan bis zu 40 Mol-% durch Aluminium ersetzt sein kann, um eine Härte zu steigern, wird schließlich die Beschichtungslage 5 mit Aluminium, Titan und Stickstoff aufgebracht, wofür die Temperatur auf etwa 800 °C bis 830 °C gesenkt wird. Die Beschichtungslage 5, die eine äußerste Beschichtungslage ist, aber nicht sein muss, wird aus einem Gas enthaltend Aluminiumtrichlorid, Stickstoff, Wasserstoff, Titantetrachlorid und einem gesondert zugeführten Gemisch von Ammoniak und Stickstoff erstellt. Somit kann in einem zweiten Schritt zur Herstellung der Zwischenschicht und in einem dritten Schritt zur Herstellung der Beschichtungslage 5 jeweils eine Prozesstemperatur gesenkt werden, was äußerst wirtschaftlich ist und eine rasche Erstellung der Beschichtung am Schneideinsatz erlaubt.

Zur Herstellung von beschichteten Körpern 1 wird jeweils eine Vielzahl von Körpern 1 in eine Anlage eingebracht und dort gleichzeitig in der vorstehend beschriebenen Weise beschichtet. Ein Prozessdruck in den CVD-Beschichtungsschritten wird dabei durch Zuführen des Prozessgases eingestellt. Während der Herstellung der Beschichtungslage 5 mit Aluminium, Titan und Stickstoff wird ein molares Verhältnis von Aluminium zu Titan so eingestellt, dass dieses kleiner als 5,0 ist.

In den nachfolgenden Tabellen sind typische Prozessparameter bei der Herstellung einer Beschichtung und Eigenschaften einzelner Beschichtungslagen dargestellt.

**Tabelle 1 - Prozessparameter**

| | Temperatur (°C) | Gaszusammensetzung/Gasfluss (l/min) bzw. TiCl₄ und CH₃CN (ml/min) |
|---|---|---|
| Beschichtungslage | | |
| TiN | 880 - 900 | TiCl₄/2,7, N₂/14, H₂/17 |
| MT-TiCN | 830 - 870 | CH₃CN/0,5, TiCl₄/2,7, N₂/19, H₂/3 |
| AlTiN | 800 - 830 | HCl-AlCl₃/2,7-0,7, TiCl₄/0,3, NH₃-N₂/0,9-4,5, H₂/64 |

**Tabelle 2 - Eigenschaften der Beschichtungslagen**

| Beschichtungslage | Schichtdicke (µm) | | Zusammensetzung |
|---|---|---|---|
| | allgemein | bevorzugt | |
| TiN | ≤ 2 | 0,25 - 0,75 | TiN |
| MT-TiCN | 1 - 10 | 2 - 5 | TiCₐN₁₋ₐ, a = 0, 4 - 0,6 |
| AlTiN | 1 - 10 | 3 - 8 | AlₓTi₁₋ₓN, x = 0,80 - 0,99 |

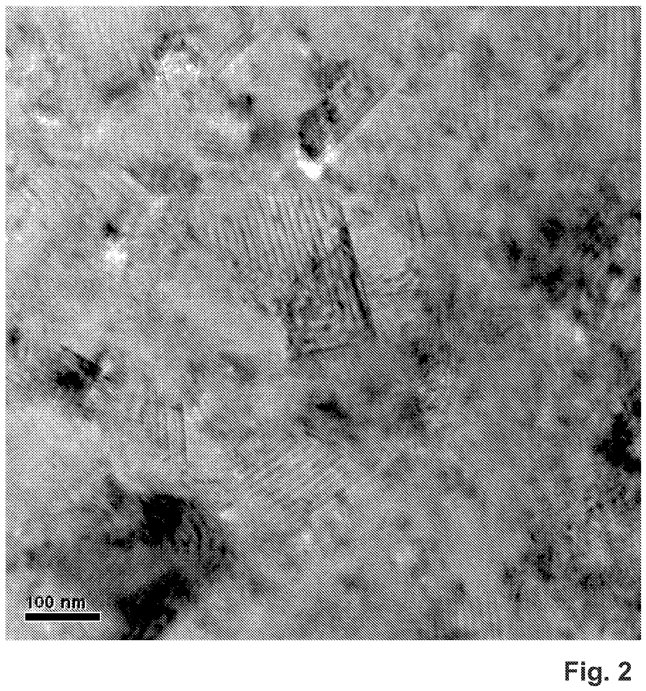

In Fig. 2 bis 4 sind transmissionselektronenmikroskopische Aufnahmen der äußersten Beschichtungslage 5 mit verschiedener Auflösung dargestellt. Wie in Fig. 2 ersichtlich ist, liegen in der Beschichtungslage 5 lamellenartige Strukturen vor, die im Querschnitt teilweise ersichtlich sind. Es wird vermutet, dass es sich hierbei um einzelne Kristallite handelt, die verschieden zur Beobachtungsrichtung ausgerichtet sind, weshalb bloß für einzelne, geeignet liegende Kristallite die Lamellenstruktur vollständig erkennbar ist. Gemäß dem Querschnitt weisen die Kristallite etwa eine Größe von 50 bis 200 nm auf.

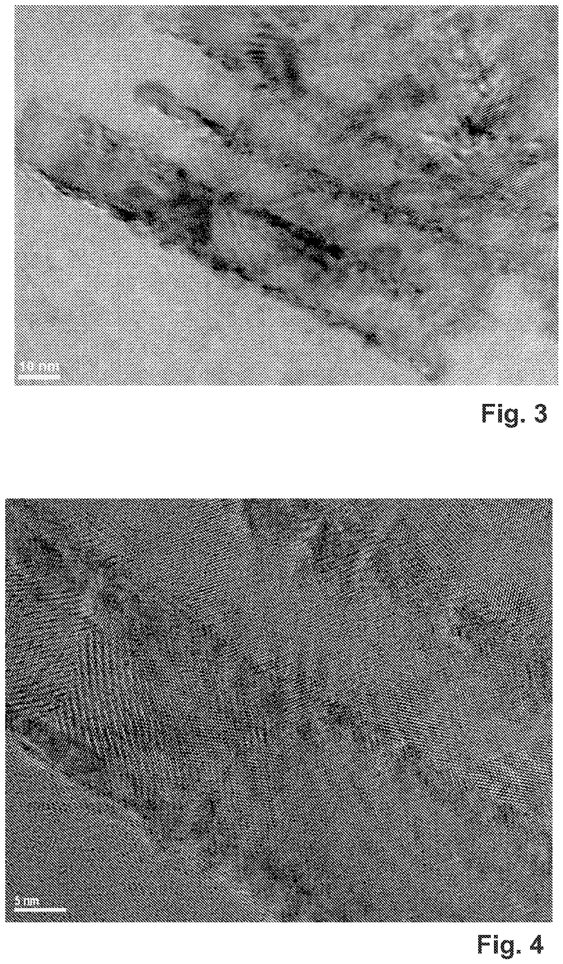

Fig. 3 zeigt einen vergrößerten Ausschnitt eines Bereiches gemäß Fig. 2. Wie ersichtlich ist, sind einzelne Lamellen gebildet. Eine Lamelle umfasst jeweils einen in Fig. 3 dunkler erscheinenden ersten Abschnitt und einen heller erscheinenden, dickeren zweiten Abschnitt. In einem Kristallit folgen mehrere derartiger Lamellen aufeinander, wobei einen Lamellendicke, also die Dicke der Summe eines ersten Abschnittes und eines zweiten Abschnittes, weniger als 25 nm beträgt. Die ersten Abschnitte bestehen aus kubischem TiN, das geringere Anteile an Aluminium aufweisen kann, wobei der molare Anteil an Aluminium vorzugsweise maximal 10 % des Titananteils beträgt. Die dickeren, zweiten Abschnitte sind aus einer hexagonalen Phase gebildet, die hinsichtlich der Metalle überwiegend Aluminium aufweist. Darüber hinaus existiert in der Beschichtungslage noch eine AlₓTi₁₋ₓN-Phase, bei welcher der Aluminiumanteil den Titananteil weit überwiegt. Insgesamt liegen somit drei Phasen vor, wobei zwei der Phasen eine lamellenartige Struktur ausbilden, die in Fig. 4 vergrößert dargestellt ist.

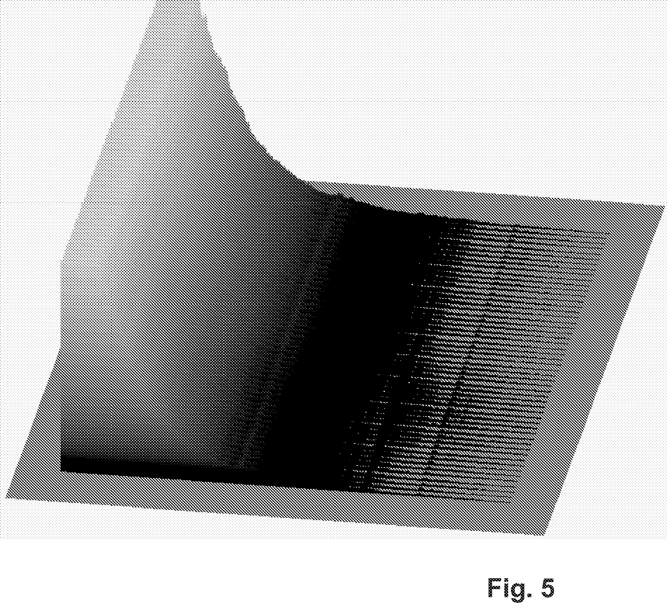

Durch eine chemische Analyse mittels Transmissionselektronenmikroskopie wird bestätigt, dass die dünneren, ersten Abschnitte der Lamellen überwiegend mit Titan als Metall gebildet sind (dunklere Bereiche in Fig. 5), wohingegen in den dickeren, zweiten Abschnitten Aluminium als Metall überwiegt (hellere Bereiche in Fig. 5).

Schneideinsätze mit einer Beschichtungslage 5 wie vorstehend beschrieben haben sich im Einsatz vor allem bei der Bearbeitung von Gusswerkstoffen, aber auch anderen metallischen Materialien als äußerst verschleißfest und oxidationsbeständig erwiesen, wobei im Einzelfall im Vergleich mit Schneidplatten, die nach einem PVD-Verfahren mit einer kubischen AlₓTi₁₋ₓN-Beschichtungslage beschichtet waren, Standzeiterhöhungen um bis zu 220 % ergeben haben.

## Patentansprüche

1. Körper (1), insbesondere Schneideinsatz, der zumindest bereichsweise eine Beschichtung aufweist, wobei die Beschichtung aus einer oder mehreren Beschichtungslagen (3, 4, 5) gebildet ist, wobei zumindest eine Beschichtungslage (5) Aluminium, Titan und Stickstoff umfasst oder aus diesen Elementen gebildet ist, **dadurch gekennzeichnet, dass** die Beschichtungslage (5) mit Aluminium, Titan und Stickstoff mittels eines CVD-Verfahrens abgeschieden ist und in dieser Beschichtungslage (5) zumindest teilweise Lamellen mit einer Lamellendicke von weniger als 100 nm vorliegen, wobei die Lamellen aufeinanderfolgende Abschnitte mit unterschiedlichen Phasen umfassen.

2. Körper (1) nach Anspruch 1, **dadurch gekennzeichnet, dass** die Lamellendicke weniger als 50 nm, vorzugsweise weniger als 35 nm, insbesondere weniger als 25 nm, beträgt.

3. Körper (1) nach Anspruch 1 oder 2, **dadurch gekennzeichnet, dass** die Lamellen Kristallite bilden, die zumindest teilweise in einem Querschnitt eine Breite von mehr als 50 nm, vorzugsweise 50 bis 200 nm, aufweisen.

4. Körper (1) nach einem der Ansprüche 1 bis 3, **dadurch gekennzeichnet, dass** die Lamellen mit wechselweise ersten Abschnitten, die überwiegend oder ausschließlich aus einer kubischen Phase bestehen, und zweiten Abschnitten, die überwiegend oder ausschließlich aus einer hexagonalen Phase bestehen, gebildet sind.

5. Körper (1) nach Anspruch 4, **dadurch gekennzeichnet, dass** die ersten Abschnitte kubisches TiN und/oder kubisches AlₓTi₁₋ₓN aufweisen.

6. Körper (1) nach Anspruch 4 oder 5, **dadurch gekennzeichnet, dass** die zweiten Abschnitte hexagonales AlN aufweisen.

7. Körper (1) nach einem der Ansprüche 4 bis 6, **dadurch gekennzeichnet, dass** die ersten Abschnitte in einem Querschnitt dünner als die zweiten Abschnitte ausgebildet sind.

8. Körper (1) nach einem der Ansprüche 1 bis 7, **dadurch gekennzeichnet, dass** in der Beschichtungslage (5) mit Aluminium, Titan und Stickstoff eine kubische TiN-, eine hexagonale AlN- und eine kubische AlₓTi₁₋ₓN-Phase vorliegen, wobei in der kubischen TiN-Phase Aluminium mit geringeren molaren Anteilen als Titan und in der hexagonalen AIN-Phase Titan mit geringeren molaren Anteilen als Aluminium vorliegen kann.

9. Körper (1) nach der Anspruch 8, **dadurch gekennzeichnet, dass** ein Anteil an hexagonaler AlN-Phase zumindest 5 %, vorzugsweise 5 % bis 50 %, insbesondere 10 % bis 35 %, beträgt.

10. Körper (1) nach einem der Ansprüche 1 bis 9, **dadurch gekennzeichnet, dass** die zumindest eine Beschichtungslage mit Aluminium, Titan und Stickstoff auf einer weiteren Beschichtungslage (4) abgeschieden ist, die längliche Kristalle aus TiCN aufweist, die sich im Mittel etwa normal zur Oberfläche der weiteren Beschichtungslage (4) erstrecken.

11. Körper (1) nach Anspruch 9 oder 10, **dadurch gekennzeichnet, dass** die Beschichtungslagen (3, 4, 5) auf einem Grundkörper (2) aus einem Hartmetall abgeschieden sind.

12. Verfahren zum Beschichten eines Körpers (1), insbesondere eines Schneideinsatzes, wobei zumindest bereichsweise eine Beschichtung aufgebracht wird, die aus einer oder mehreren Beschichtungslagen (3, 4, 5) gebildet wird, wobei zumindest eine Beschichtungslage (5) mit Aluminium, Titan und Stickstoff gebildet wird, **dadurch gekennzeichnet, dass** die Beschichtungslage (5) mit Aluminium, Titan und Stickstoff mittels eines CVD-Verfahrens und zumindest teilweise mit einer lamellenartigen Struktur mit Lamellen mit einer Lamellendicke von weniger als 100 nm und aufeinanderfolgenden Abschnitten mit unterschiedlichen Phasen abgeschieden wird.

13. Verfahren nach Anspruch 12, **dadurch gekennzeichnet, dass** die zumindest eine Beschichtungslage (5) mit Aluminium, Titan und Stickstoff gleichzeitig auf einer Vielzahl von Körpern (1) abgeschieden wird.

14. Verfahren nach Anspruch 13, **dadurch gekennzeichnet, dass** ein Beschichten in einer Anlage erfolgt, in welche die Körper (1) gleichzeitig eingebracht werden.

15. Verfahren nach einem der Ansprüche 12 bis 14, **dadurch gekennzeichnet, dass** die zumindest eine Beschichtungslage (5) mit Aluminium, Titan und Stickstoff bei einem Druck von mehr als 20 mbar, bevorzugt 20 bis 80 mbar, abgeschieden wird.

16. Verfahren nach Anspruch 15, **dadurch gekennzeichnet, dass** der Druck während des Beschichtens durch Zuführen eines Prozessgases eingestellt wird.

17. Verfahren nach einem der Ansprüche 12 bis 16, **dadurch gekennzeichnet, dass** die zumindest eine Beschichtungslage (5) mit Aluminium, Titan und Stickstoff bei einer Temperatur von 800 °C bis 830 °C abgeschieden wird.

18. Verfahren nach Anspruch 17, **dadurch gekennzeichnet, dass** die zumindest eine Beschichtungslage (5) mit Aluminium, Titan und Stickstoff aus einer Gasphase abgeschieden wird, bei der ein molares Verhältnis von Aluminium zu Titan kleiner als 5,0, vorzugsweise kleiner als 4,5, insbesondere 2,5 bis 4,2, ist.

## Claims

1. A body (1), in particular a cutting element, which comprises a coating at least in regions, wherein the coating is formed from one or more coating layers (3, 4, 5), wherein at least one coating layer (5) comprises aluminium, titanium and nitrogen or is formed from these elements, **characterized in that** the coating layer (5) with aluminium, titanium and nitrogen is deposited by means of a CVD process and in this coating layer (5), lamellae having a lamellar thickness of less than 100 nm are present at least in sections, wherein the lamellae comprise successive sections with different phases.

2. The body (1) as claimed in claim 1, **characterized in that** the lamellar thickness is less than 50 nm, preferably less than 35 nm, in particular less than 25 nm.

3. The body (1) as claimed in claim 1 or claim 2, **characterized in that** the lamellae form crystallites which at least in part have a width in a cross section of more than 50 nm, preferably 50 to 200 nm.

4. The body (1) as claimed in one of claims 1 to 3, **characterized in that** the lamellae are formed alternately with first sections which predominantly or exclusively consist of a cubic phase, and second sections which predominantly or exclusively consist of a hexagonal phase.

5. The body (1) as claimed in claim 4, **characterized in that** the first sections are composed of cubic TiN and/or cubic AlₓTi₁₋ₓN.

6. The body (1) as claimed in claim 4 or claim 5, **characterized in that** the second sections are composed of hexagonal AlN.

7. The body (1) as claimed in one of claims 4 to 6, **characterized in that** the first sections are formed with a cross section which is thinner than that of the second sections.

8. The body (1) as claimed in one of claims 1 to 7, **characterized in that** a cubic TiN phase, a hexagonal AlN phase, and a cubic AlₓTi₁₋ₓN phase are present in the coating layer (5) with aluminium, titanium and nitrogen, wherein in the cubic TiN phase, aluminium can be present in smaller molar proportions than titanium and in the hexagonal AlN phase, titanium can be present in smaller molar proportions than aluminium.

9. The body (1) as claimed in claim 8, **characterized in that** a proportion of hexagonal AlN phase is at least 5 %, preferably 5 % to 50 %, in particular 10 % to 35 %.

10. The body (1) as claimed in one of claims 1 to 9, **characterized in that** the at least one coating layer with aluminium, titanium and nitrogen is deposited on an additional coating layer (4) which is composed of elongated crystals of TiCN which on average extend approximately perpendicular to the surface of the additional coating layer (4).

11. The body (1) as claimed in claim 9 or claim 10, **characterized in that** the coating layers (3, 4, 5) are deposited onto a main body (2) produced from a hard metal.

12. A method for coating a body (1), in particular a cutting element, wherein a coating is applied at least in regions, the coating being formed from one or more coating layers (3, 4, 5), wherein at least one coating layer (5) is formed from aluminium, titanium and nitrogen, **characterized in that** the coating layer (5) with aluminium, titanium and nitrogen is deposited by means of a CVD process and is deposited at least in sections with a lamellar structure with lamellae having a lamellar thickness of less than 100 nm and successive sections with different phases are deposited.

13. The method as claimed in claim 12, **characterized in that** the at least one coating layer (5) with aluminium, titanium and nitrogen is deposited simultaneously on a plurality of bodies (1).

14. The method as claimed in claim 13, **characterized in that** coating is carried out in a unit into which the bodies (1) are introduced simultaneously.

15. The method as claimed in one of claims 12 to 14, **characterized in that** the at least one coating layer (5) with aluminium, titanium and nitrogen is deposited at a pressure of more than 20 mbar, preferably 20 to 80 mbar.

16. The method as claimed in claim 15, **characterized in that** the pressure is adjusted during coating by supplying a process gas.

17. The method as claimed in one of claims 12 to 16, **characterized in that** the at least one coating layer (5) with aluminium, titanium and nitrogen is deposited at a temperature of 800 °C to 830 °C.

18. The method as claimed in claim 17, **characterized in that** the at least one coating layer (5) with aluminium, titanium and nitrogen is deposited from a gas phase in which a molar ratio of aluminium to titanium is less than 5.0, preferably less than 4.5, in particular 2.5 to 4.2.

## Revendications

1. Corps (1), notamment insert de coupe, qui comporte au moins par endroits un revêtement, le revêtement étant formé d'une ou de plusieurs couches de revêtement (3, 4, 5), au moins une couche de revêtement (5) comprenant de l'aluminium, du titane et de l'azote ou étant formée de ces éléments, **caractérisé en ce que** la couche de revêtement (5) est déposée avec de l'aluminium, du titane et de l'azote au moyen d'un procédé CVD et dans cette couche de revêtement (5), des lamelles d'une épaisseur de lamelle de moins de 100 nm sont présentes au moins en partie, les lamelles comprenant des sections successives avec différentes phases.

2. Corps (1) selon la revendication 1, **caractérisé en ce que** l'épaisseur des lamelles s'élève à moins de 50 nm, de préférence à moins de 35 nm, notamment à moins de 25 nm.

3. Corps (1) selon la revendication 1 ou 2, **caractérisé en ce que** les lamelles forment des cristallites, qui au moins en partie, dans une section transversale présentent une épaisseur de plus de 50 nm, de préférence de 50 à 200 nm.

4. Corps (1) selon l'une quelconque des revendications 1 à 3, **caractérisé en ce que** les lamelles sont formées alternativement de premières sections, qui sont constituées majoritairement ou exclusivement d'une phase cubique et de deuxièmes sections, qui sont constituées majoritairement ou exclusivement d'une phase hexagonale.

5. Corps (1) selon la revendication 4, **caractérisé en ce que** les premières sections comportent du TiN cubique et/ou de l'AlₓTi₁₋ₓN cubique.

6. Corps (1) selon la revendication 4 ou 5, **caractérisé en ce que** les deuxièmes sections comportent de l'AlN hexagonal.

7. Corps (1) selon l'une quelconque des revendications 4 à 6, **caractérisé en ce que** les premières sections sont conçues en étant plus minces dans une section transversale que les deuxièmes sections.

8. Corps (1) selon l'une quelconque des revendications 1 à 7, **caractérisé en ce que** dans la couche de revêtement (5) avec de l'aluminium, du titane et de l'azote sont présents un TiN cubique, un AlN hexagonal et une phase cubique d'AlₓTi₁₋ₓN-Phase, dans la phase TiN cubique pouvant être présent de l'aluminium avec des proportions molaires plus faibles que le titane et dans la phase AlN hexagonale pouvant être présent du titane avec des proportions molaires plus faibles que l'aluminium.

9. Corps (1) selon la revendication 8, **caractérisé en ce qu'**une proportion de phase AIN hexagonale s'élève à au moins 5 %, de préférence à de 5 % à 50 %, notamment à de 10 % à 35 %.

10. Corps (1) selon l'une quelconque des revendications 1 à 9, **caractérisé en ce que** l'au moins une couche de revêtement avec de l'aluminium, du titane et de l'azote est déposée sur une couche de revêtement (4) supplémentaire, qui comporte des cristaux oblongs en TiCN, qui en moyenne, s'étendent approximativement à la normale de la surface de la couche de revêtement (4) supplémentaire.

11. Corps (1) selon la revendication 9 ou 10, **caractérisé en ce que** les couches de revêtement (3, 4, 5) sont déposées sur un Corps de base (2) en un métal dur.

12. Procédé, destiné à revêtir un corps (1), notamment un insert de coupe, lors duquel on applique au moins par endroits un revêtement que l'on forme à partir d'une ou de plusieurs couches de revêtement (3, 4, 5), au moins une couche de revêtement (5) étant formée avec de l'aluminium, di titane et de l'azote, **caractérisé en ce qu'**on dépose la couche de revêtement (5) avec de l'aluminium, du titane et de l'azote au moyen d'un procédé CVD et au moins en partie avec une structure lamellaire avec des lamelles d'une épaisseur de lamelle de moins de 100 nm et des sections successives avec différentes phases.

13. Procédé selon la revendication 12, **caractérisé en ce que** l'on dépose la couche de revêtement (5) avec de l'aluminium, du titane et de l'azote simultanément sur une pluralité de corps (1).

14. Procédé selon la revendication 13, **caractérisé en ce qu'**une opération de revêtement s'effectue dans une installation dans laquelle les corps (1) sont introduits simultanément.

15. Procédé selon l'une quelconque des revendications 12 à 14, **caractérisé en ce que** l'on dépose l'au moins une couche de revêtement (5) avec de l'aluminium, du titane et de l'azote à une pression de plus de 20 mbar, de préférence de 20 à 80 mbar.

16. Procédé selon la revendication 15, **caractérisé en ce qu'**on règle la pression pendant l'opération de revêtement par alimentation d'un gaz de processus.

17. Procédé selon l'une quelconque des revendications 12 à 16, **caractérisé en ce qu'**on dépose l'au moins une couche de revêtement (5) avec de l'aluminium, du titane et de l'azote à une température de 800 °C à 830 °C.

18. Procédé selon la revendication 17, **caractérisé en ce que** l'on dépose l'au moins une couche de revêtement (5) avec de l'aluminium, du titane et de l'azote à partir d'une phase gazeuse, dans laquelle une proportion molaire de l'aluminium au titane est inférieure à 5,0, de préférence inférieure à 4,5, notamment de 2,5 à 4,2,
